# EUROPEAN PATENT APPLICATION

(11) **EP 4 734 713 A1**
(43) Date of publication of application: **29.04.2026**
(21) Application number: 24383182.3
(22) Date of filing: 28.10.2024
(51) Int. Cl.: H10F 71/00

(54) **SOLAR CELL STRINGS TRANSPORTING DEVICE AND METHOD THEREOF**

(71) Applicant: Mondragon Assembly, S.Coop, 20550 Aretxabaleta (ES)
(72) Inventor: ARAGONES REBOLLO, Jose Maria, 20550 Aretxabaleta (ES); VALOR VALOR, Antonio, 20550 Aretxabaleta (ES); AGUERRE, Jean-philippe, 20550 Aretxabaleta (ES); APRAIZ ARENAZA, Aitor, 20550 Aretxabaleta (ES)
(74) Representative: Galbaian S.Coop.

(57) **Abstract**

The invention relates to a solar cell strings transport device and a method for operating the device (100). The device (100) comprises a plurality of holding members (2) distributed along a longitudinal direction (LD) and configured to hold at least one solar cell string (200), and a frame (1) to which the holding members (2) are associated. At least one of the holding members (2) is movable with respect to at least one other holding member (2) in an adjustment direction (AD) which is different from the longitudinal direction (LD).

## Description

### TECHNICAL FIELD

The present invention relates to solar cell strings transport devices to methods for operating such transport devices.

### PRIOR ART

Solar panels or modules are formed by strings of solar cells connected together, and a solar cell string comprises a plurality of solar cells connected in series by conductive wires. The solar cell strings are manufactured so that they are flat, and typically the solar modules that are arranged on homes or land are rectangular and flat.

However, since the advent of electric vehicles, the aim is to incorporate solar modules in electric vehicles in order to charge the batteries integrated in these vehicles, and due to the configuration of the vehicles, it is preferable that the modules for these vehicles not to be flat and are preferably curved, following the external appearance of the vehicles. Also in other sectors the application of non-flat (preferably curved) photovoltaic panels is becoming of high interest, e.g. in marine applications (recreational boats) or integrated photovoltaics in greenhouses (agri-voltaics). Non-flat modules are described for example in EP3618127A1, where these modules are shown integrated in vehicles.

### DISCLOSURE OF THE INVENTION

The object of the invention is to provide a solar cell strings transport device and a method of operation of said transport device, as defined in the claims.

A first aspect of the invention relates to a transport device which is adapted to transport at least one solar cell string and which comprises a plurality of holding members distributed along a longitudinal direction and configured to hold the solar cell string, and a frame to which the holding members are associated. In this way, the holding members move together manner with said frame when said frame is moved.

At least one of the holding members is movable relative to at least one other holding member (whereby a relative displacement can be generated between at least two holding members), moving relative to the frame, in an adjustment direction which is different from the longitudinal direction.

In this way, when a relative displacement is caused between at least two holding members holding a solar cell string, the solar cell string is deformed since at least the parts or areas of the solar cell string associated with these holding members between which the relative displacement is caused also support an analogous relative displacement. This allows the solar cell string to be given the desired shape before being placed on the final substrate in a safe and controlled manner, even in cases where the substrate is not flat, without the solar cell string being subjected to stresses that would adversely affect its structure or even cause the solar cell string to break.

A second aspect of the invention relates to a method for operating a Solar cell strings transport device, wherein a solar cell string is held by a plurality of holding members and said solar cell string so held is transported to a required position for being disposed on a substrate. The method comprises, with the solar cell string held, deforming the solar cell string by displacing at least one of the holding members with respect to at least one other holding member, and releasing said solar cell string onto the substrate once deformed. The advantages described for the transport device are also obtained with the proposed method.

These and other advantages and features of the invention will become apparent in view of the figures and the detailed description of the invention.

### DESCRIPTION OF THE DRAWINGS

Figure 1 shows schematically an embodiment of the transport device according to the invention.
Figure 2 shows a plan view of a solar cell string.
Figure 3 shows a solar cell string arranged on a non-flat substrate.
Figure 4 shows the transport device of figure 1, with holding members of the device moved with respect to the frame of the device.
Figure 5 shows another embodiment of the transport device according to the invention, with a flexible plate.
Figure 6 shows another embodiment of the transport device according to the invention, with a flexible plate.
Figure 7 shows the transport device of figure 6, with a flexible plate deformed in another direction.
Figure 8 shows an adjustment device associated with a holding member of an embodiment of the transport device according to the invention.
Figure 9 shows the adjusting device of figure 8, having modified the orientation of the holding member with respect to the orientation depicted in figure 8.
Figure 10 shows another embodiment of the transport device of the invention.

### DETAILED DISCLOSURE OF THE INVENTION

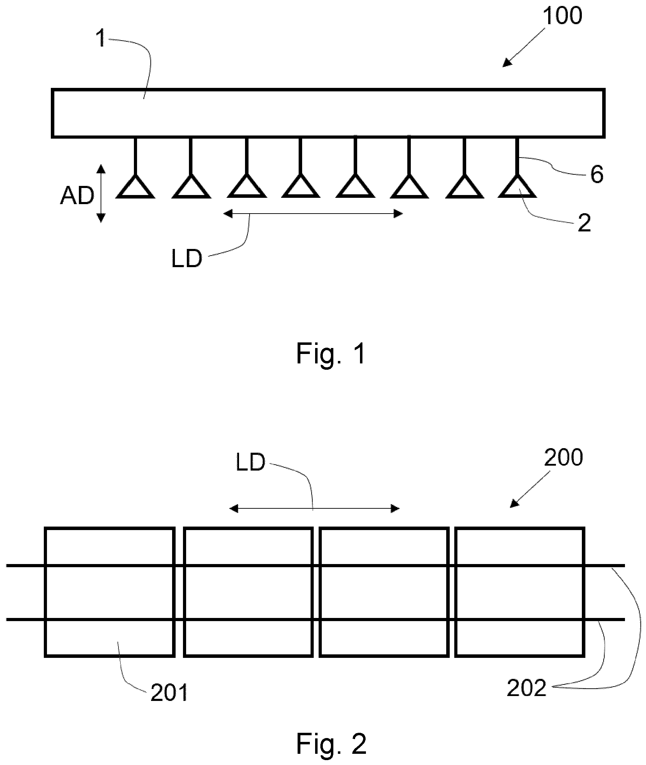

The proposed transport device 100, as shown by way of example in Figure 1, is configured to transport at least one solar cell string 200 as the one shown by way of example in Figure 2. The transport device 100 is configured to transport solar cell strings 200 in an installation for manufacturing solar panels and is configured to pick up the solar cell string 200, to transport it to a required position of the installation, and, being in the required position, to release it so that the solar cell string 200 is arranged on a substrate 300 (preferably a glass).

A solar cell string 200 comprises a plurality of solar cells 201 connected in series by electrically conductive connectors 202. The solar cell string 200 is manufactured such that it is a flat string.

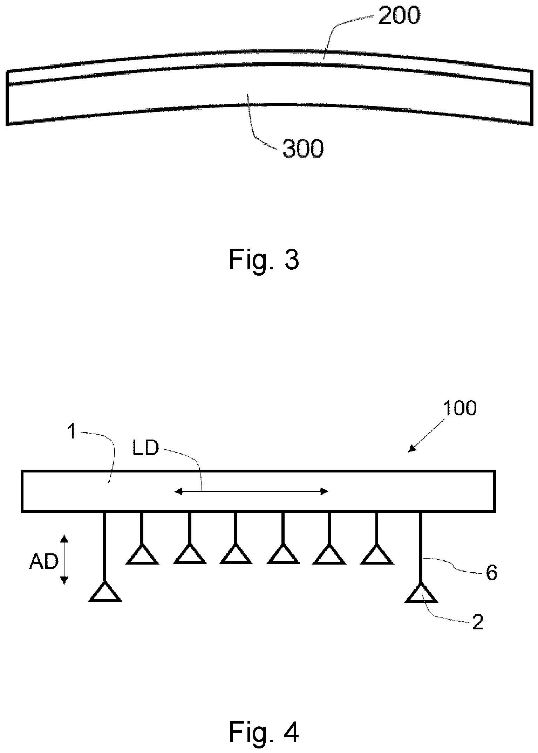

To date, the substrates 300 on which the solar cell strings 200 are disposed are usually flat, so that the solar cell strings 200, which are flat, are easily and safely disposed on such substrates 300. However, at present the substrates 300 may not be flat (they may be curved for example, as depicted in Figure 3). Conventional transport devices 100 are forced to drop part of the solar cell string from a considerable height, causing crashes and breakages in most cases. The proposed transport device 100 is adapted to be able to arrange the solar cell strings 200 on such non-flat substrates 300 in a simple and safe way and to minimise the stresses induced in the solar cell string 200.

The transport device 100 comprises a plurality of holding members 2 which are distributed along a longitudinal direction LD and which are configured to hold the solar cell string 200, and a frame 1 to which the holding members 2 are associated such that the holding members 2 move together with the frame 1, when the frame 1 is moved. This allows the fastened solar cell string 200 to be moved from one location to another as required.

The longitudinal direction LD preferably corresponds to a direction that extends along a longitudinal plane of the solar cell string 200 attached or to be attached, as shown in figure 2.

Preferably, each holding member 2 is configured to hold the solar cell string 200 by suction and may comprise, for example, a suction cup or analogous element. The transport device 100 preferably comprises the necessary elements (not depicted in the figures) to enable the holding device 2 to exert suction to hold the solar cell string 200, such as a vacuum or suction generator communicating with the holding device 2. Such necessary elements may be conventional elements employed today for that task.

The fact that a holding member 2 is associated with the frame 1 implies that it can be directly attached to the frame 1 or attached to the frame 1 through another element (indirectly attached), as will be detailed below.

At least one of the holding members 2 is movable relative to at least one other holding member 2 in an adjustment direction AD which is different from the longitudinal direction LD and is also movable relative to the frame 1 (see figure 4, where holding members 2 are shown in different positions). This makes it possible to deform the solar cell string 200 that is held (to modify its shape), by simply causing relative displacement between at least two holding members 2 with the solar cell string 200 held by said holding members 2, this relative displacement or positioning between different holding members 2 being what allows the deformation of the solar cell string 200. In this way, the solar cell string 200 can be deformed in a controlled manner so that said solar cell string 200 acquires the shape of the substrate 300 on which it is to be arranged, while being held by the transport device 100, ensuring a correct arrangement on said substrate 300.

The adjustment direction AD is preferably a direction perpendicular to the longitudinal direction LD and in a plane perpendicular to the plane of the solar cell string 200 attached or to be attached. Preferably the longitudinal direction LD is a horizontal direction and the adjustment direction AD is a vertical direction or comprises a vertical component.

Hereinafter, for clarity, a holding member 2 that is displaceable with respect to at least one other holding member 2 will be referred to as a displaceable holding member 2.

Preferably the holding device 100 comprises a plurality of displaceable holding members 2, such that the transport device 100 is more flexible in terms of the deformation options it offers, and it is easier to deform the solar cell string 200 into the shape of the corresponding substrate 300. For example, it is possible to deform the solar cell string 200 into curved "half-U" shapes, inverted "half-U" shapes, "U" shapes, or inverted "U" shapes, which are the most common shapes for non-flat solar cell strings 200.

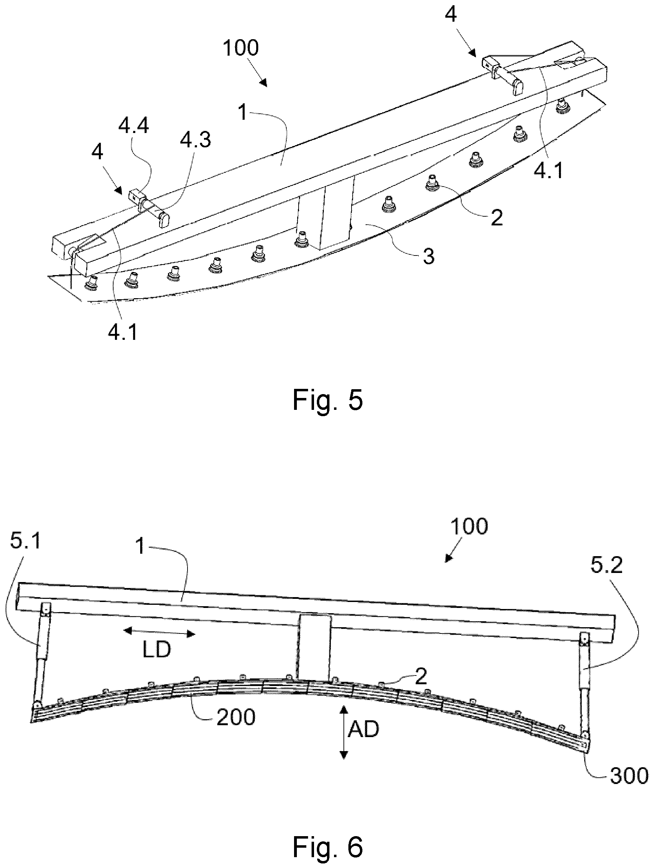

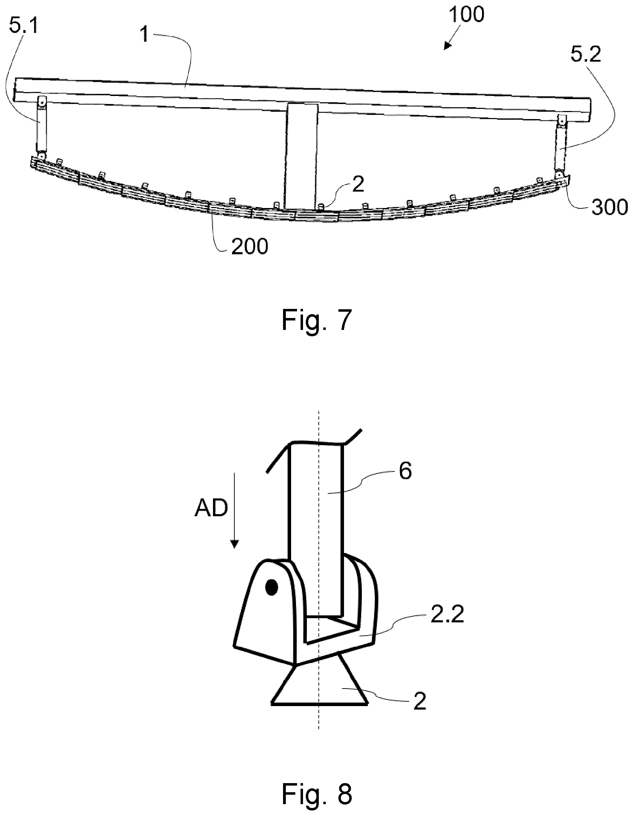

In some embodiments, as in the embodiments of Figures 5 to 7 for example, the transport device 100 comprises a flexible plate 3 which is attached to or associated to the frame 1, and the holding members 2 are attached to at least the flexible plate 3. When the transport device 100 holds the solar cell string 200, the solar cell string 200 is supported by the flexible plate 3. In these embodiments, the flexible plate 3 is deformed to cause the deformation of the solar cell string 200. Preferably, the flexible plate 3 is attached to the frame 1 in one point or area to facilitate its deformation, and this point or area can be at the middle of the flexible plate 3 along the longitudinal direction LD (see figures 6 and 7).

The flexible plate 3 may comprise, for example, a respective hole associated with each holding member 2, to allow the holding members 2 to hold the solar cell string 200. The hole allows the respective holding member 2 to act on the solar cell string 200 to hold it.

The flexible plate 3 is attached to the frame 1 at least through actuating means of the transport device 100, such that the flexible plate 3 moves together with the frame 1 when the frame 1 is moved, for example to transport the held solar cell string 200 from one location to another. The actuating means are configured to cause deformation of the flexible plate 3 when actuated. In these embodiments, the holding members 2 are attached to the flexible plate 3 but preferably not to the frame 1 (thus being associated with the frame 1 via the flexible plate 3), such that when the flexible plate 3 is caused to deform, the holding members 2 are displaced (although some holding members 2 may remain in their initial position if forced to do so by the deformation of the flexible plate 3, for example the one arranged at the central point) and the solar cell string 200 held by said holding members 2 is caused to deform. The adjustment direction AD in which the holding members 2 move may vary from one holding member 2 to another, i.e. the adjustment directions AD associated with different holding members 2 are not parallel, as can be seen from Figures 5 to 7. The solar cell string 200 deforms to the same extent as the flexible plate 3 and acquires the required shape.

In some embodiments, as in the embodiment shown in figure 5, the actuation means comprise a wire 4.1, thread or cable attached to the flexible plate 3, and an adjustment actuator 4 configured to move the wire 4.1 when actuated in one direction or in the opposite direction. When the wire 4.1 is caused to move, at least the part of the flexible plate 3 attached to the wire 4.1 is actuated to move towards the frame 1 or in the opposite direction depending on the direction of travel of the wire 4.1. Preferably the actuating means comprise at least a first wire 4.1 and a second wire 4.1 attached to different points of the flexible plate 3, as shown in the example of figure 6, in such a way that the flexible plate 3 can be deformed by acting on the flexible plate 3 at least two different points, whereby the flexible plate 3 can be deformed to a greater extent (for example, it can acquire an inverted U or U-shape).

In some embodiments not shown in the figures, the frame 1 extends in the longitudinal direction LD and the adjustment actuator 4 comprises a carriage which is attached to the frame 1 with the possibility of movement in the longitudinal direction LD and in the opposite direction, and a motor configured to move the carriage. The wire 4.1 is attached to the flexible plate 3 and the carriage. Depending on the direction of movement of the carriage, the wire 4.1 is tensioned or released, causing the flexible plate 3 to deform in one direction or the other: when moving in the longitudinal direction LD it is tensioned; and when moving in the opposite direction it is released, causing the flexible plate 3 to deform due to gravity.

In other embodiments, as in the embodiment shown in figure 6, the frame 1 extends in the longitudinal direction LD and the adjustment actuator 4 comprises a rotor 4.3 attached to the frame 1 with the possibility of rotation, and a motor 4.4 to cause the rotation of the rotor 4.3. The wire 4.1 is attached to and associated with the rotor 4.3 in such a way that, depending on the direction of rotation of the rotor 4.3, it is wound around or unwound from the rotor 4.3, moving in the longitudinal direction LD or in the opposite direction. Depending on the direction of rotation, the wire 4.1 is tensioned or released, causing the flexible plate 3 to deform in one direction or the other: when it rotates in one direction it is tensioned (figure 5); and when it rotates in the opposite direction it is released, causing the flexible plate 3 to deform due to gravity.

In other embodiments, the actuating means comprise at least one actuator attached between the frame 1 and the flexible plate 3, the flexible plate 3 being deformed by an actuation of the actuator. Preferably the actuation means comprise a first actuator 5.1 and a second actuator 5.2 attached to the frame 1 and to different points of the flexible plate 3, whereby the flexible plate 3 can be deformed to a greater extent (e.g. it can acquire an inverted U or U-shape). An actuator 5.1, 5.2 may comprise a motorised shaft or a cylinder for example. In the case of a cylinder, the cylinder comprises a housing and a piston rod which is longitudinally movable relative to the housing (or it is the housing which moves relative to the piston rod), the piston rod being attached to one of the two members between the flexible plate 3 and the frame 1 and the housing being attached to the other of said two members. Upon actuation, the cylinder expands or contracts (causing a relative displacement between the housing and the piston rod), thus causing the flexible plate 3 to deform in one direction (Figure 6) or in the opposite direction (Figure 7). In some of these embodiments, as shown in figures 6 and 7 for example, the frame 1 also extends in a longitudinal direction LD.

In other embodiments, the transport device 100 lacks a flexible plate 3 and the holding members 2 are attached to the frame 1, as depicted in the embodiment of Figures 1 and 4. Each holding member 2 is attached to the frame 1 by means of a corresponding joining device 6. At least the joining devices 6 associated with the movable holding members 2 are configured so as to be able to move the holding members 2, and preferably comprise a cylinder or a motorised shaft.

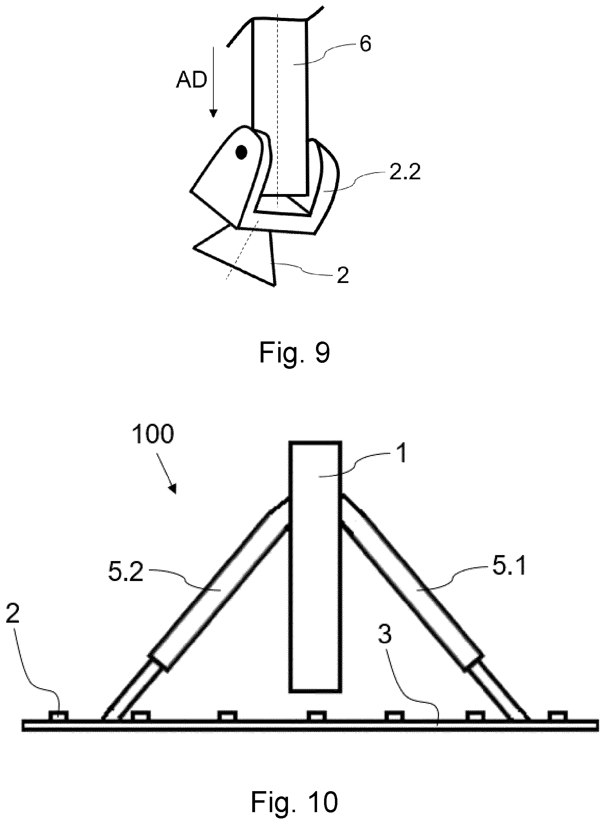

Preferably, the transport device 100 comprises an adjustment device 2.2 associated with each movable holding member 2, as depicted by way of example in figure 8. The adjustment device 2.2 is arranged between the joining device 6 and the holding member 2 and is configured to be able to modify the orientation of the holding member 2 with respect to the adjustment direction AD, as depicted in figure 9. The latter allows the corresponding holding member 2 to adapt to the shape of the part of the solar cell string 200 it holds, during deformation of said solar cell string 200. Preferably the transport device 100 comprises an adjustment device 2.2 associated with each holding member 2.

In some embodiments, as in the embodiments shown in figures 1, 4, 5, 6 and 7, the frame 1 extends in the longitudinal direction LD and the holding members 2 face the frame 1. In other embodiments the frame 1 may comprise any other shape, such as a shape in which it extends vertically (see figure 10).

A second aspect of the invention relates to a method for operating a transport device 100 for solar cell strings 200. In the method, the transport device 100 holds at least one solar cell string 200 with a plurality of holding members 2 distributed along a longitudinal direction LD and transports said held solar cell string 200 to a required position (typically on top of a substrate 300 on which the solar cell string 200 is to be supported).

The method further comprises, with the solar cell string 200 held, displacing at least one of the holding members 2 relative to another holding member 2 in an adjustment direction AD other than the longitudinal direction LD, in order to deform the solar cell string 200 and thus cause the solar cell string 200 to assume the shape of the substrate 300. Depending on the required shape, a plurality of holding members 2 may be displaced.

The longitudinal direction LD preferably corresponds to a direction that extends along a longitudinal plane of the solar cell string 200 attached or to be attached.

The adjustment direction AD is preferably a direction perpendicular to the longitudinal direction LD and in a plane perpendicular to the plane of the solar cell string 200 attached or to be attached. Preferably the longitudinal direction LD is a horizontal direction and the adjustment direction AD is a vertical direction.

In some embodiments, a direct displacement of the holding member 2 is caused (as in the method applied in a transport device 100 as shown in figures 1 and 4).

In other embodiments, the holding member 2 is moved indirectly (as in the method applied in a transport device 100 as shown in Figure 5 or as shown in Figures 6 and 7). In these embodiments, holding the solar cell string 200 causes the solar cell string 200 to rest against a flexible plate 3. The holding members 2 are attached at least to the flexible plate 3 as described for the first aspect of the invention, in the corresponding embodiment, and in the method deformation of the flexible plate 3 is caused by acting on said flexible plate 3, to deform the solar cell string 200, with said deformation of the flexible plate 3 causing the displacement of at least one holding member 2 relative to another holding member 2 in the adjustment direction AD.

The method may be adapted to operate a transport device 100 as described for the first aspect of the invention in any of its embodiments and/or configurations. The method may thus comprise an embodiment or configuration adapted to the embodiment or configuration of the transport device 100. Thus, what is described for the transport device 100 is also valid and applicable to the method if so required, and vice versa.

## Claims

1. Solar cell strings transport device, the transport device (100) comprising a plurality of holding members (2) distributed along a longitudinal direction (LD) and configured to hold at least one solar cell string (200), and a frame (1) to which the holding members (2) are associated, **characterised in that** at least one of the holding members (2) is movable with respect to at least one other holding member (2) in an adjustment direction (AD) which is different from the longitudinal direction (LD).

2. Solar cell strings transport device according to claim 1, wherein a holding member (2) is configured to move relative to the frame (1) when displaced relative to another holding member (2).

3. Solar cell strings transport device according to claim 1 or 2, comprising a plurality of holding members (2) movable with respect to at least one other holding member (2) in the adjustment direction (AD).

4. Solar cell strings transport device according to any of claims 1 to 3, comprising a flexible plate (3) to which the holding members (2) are attached, and actuating means which are associated to the frame (1) and to the flexible plate (3), and which are configured to cause the flexible plate (3) to deform when actuated causing a relative displacement between at least two holding members (2) with such deformation, the solar cell string (200) held by the transport device (100) being deformed.

5. Solar cell strings transport device according to claim 4, wherein the actuation means comprise a configuration at least selected from among
- a first configuration comprising a wire (4.1) or cable attached to the flexible plate (3) and an adjustment actuator (4) configured to move the wire (4.1) when actuated, in one direction or in the opposite direction, the flexible plate (3) being caused to deform when the wire (4.1) is moved and at least one holding member (2) being caused to move relative to the frame (1) when the flexible plate (3) is deformed; and
- a second configuration comprising at least one actuator (5.1, 5.2) attached to the frame (1) and to the flexible plate (3), the flexible plate (3) being caused to deform by an actuation of the actuator (5.1, 5.2) and the at least one holding member (2) being displaced relative to the frame (1) when the flexible plate (3) is deformed.

6. Solar cell strings transport device according to claim 5, wherein the actuation means comprise the second configuration and the actuator (5.1, 5.2) is a cylinder or a motorised shaft.

7. Solar cell strings transport device according to any of claims 1 to 6, wherein the frame (1) extends in the longitudinal direction (LD), the holding members (2) facing the frame (1).

8. Solar cell strings transport device according to any of claims 1 to 3, wherein the frame (1) extends in the longitudinal direction (LD), each holding member (2) being attached to the frame (1) via a respective joining device (6), and each joining device (6) being attached to the respective holding member (2) and the frame (1).

9. Solar cell strings transport device according to claim 8, wherein at least the joining device (6) which is associated with a holding member (2) which is movable with respect to at least one other holding member (2) is configured to be able to move said holding member (2) in the adjustment direction (AD), said joining device (6) preferably comprising a cylinder or a motor-driven shaft.

10. Solar cell strings transport device according to claim 9, comprising a adjusting device (2.2) for at least each holding member (2) which is movable with respect to at least one other holding member (2), the adjusting device (2.2) being arranged between the corresponding holding member (2) and joining device (6) and being configured to be able to change the orientation of said holding member (2) with respect to the adjustment direction (AD).

11. Solar cell strings transport device according to any of claims 1 to 10, wherein the holding members (2) are configured to hold the solar cell string (200) by suction.

12. Installation for the manufacture of solar panels comprising at least one transport device (100) for solar cells (200) according to any of the preceding claims.

13. Method of operation of a solar cell strings transport device, wherein at least one solar cell string (200) is held by a plurality of holding members (2) distributed along a longitudinal direction (LD), and the solar cell string (200) thus held is transported to a required position to be arranged on a substrate (300), **characterised in that** the method comprises, with the solar cell string (200) held, displacing at least one of the holding members (2) with respect to at least one other holding member (2), thereby deforming the clamped solar cell string (200), and once deformed, releasing said solar cell string (200) onto the substrate (300).

14. Method according to claim 13, wherein a holding member (2) is acted upon directly to cause displacement of said holding member (2) relative to at least one other holding member (2).

15. Method according to claim 14, wherein holding the solar cell string (200) causes said solar cell string (200) to rest against a flexible plate (3) of the transport device (100) to which the holding members (2) are attached, the flexible plate (3) being acted on to be deformed, the displacement of at least one holding member (2) being caused with said deformation of the flexible plate (3).
